# EUROPEAN PATENT SPECIFICATION

(11) **EP 0 596 393 B1**
(45) Date of publication and mention of the grant of the patent: **07.01.1998**
(21) Application number: 93117351.2
(22) Date of filing: 26.10.1993
(51) Int. Cl.: H01L 21/60

(54) **Method of applying bumps on a semiconductor device and connecting it with a printed circuit board**
Verfahren zum Aufbringen von Kontakthöckern auf einer Halbleitervorrichtung sowie zum Verbinden dieser Vorrichtung mit einer Leiterplatte
Procédé d'application de plots de contact sur un dispositif semi-conducteur et de connexion du dispositif avec un circuit imprimé

(30) Priority: 27.10.1992 JP 288533/92
(43) Date of publication of application: 11.05.1994
(73) Proprietor: MATSUSHITA ELECTRIC INDUSTRIAL CO., LTD., Kadoma-shi, Osaka 571 (JP)
(72) Inventor: Kawakita, Tetuo, Takatsuki-shi, Osaka 569 (JP); Hatada, Kenzo, Katano-shi, Osaka 576 (JP)
(74) Representative: Grünecker, Kinkeldey, Stockmair & Schwanhäusser Anwaltssozietät

(56) References cited:
- EP-A- 0 208 494
- US-A- 4 749 120
- PATENT ABSTRACTS OF JAPAN vol. 11, no. 292 (E-543)(2739) 19 September 1987 & JP-A-62 090 959 (MATSUSHITA ELECTRIC IND CO LTD)

## Description

### BACKGROUND OF THE INVENTION

The present invention relates to a method of fabricating a semiconductor apparatus in which the electrodes of a semiconductor device are connected to the electrodes of a circuit board with bumps interposed therebetween.

In recent years, there have been developed an increasing number of electronic apparatus in which a plurality of semiconductor devices are mounted. These electronic apparatus include a memory card, liquid-crystal display and EL display, each of which requires a technique of mounting a plurality of LSI chips on a substrate with a specified area so as to provide a high-density and flat-type apparatus.Among effective means to realize such high-density mounting of LSI chips is a micro-bump bonding method (hereinafter referred to as the MBB method). According to the method, bump electrodes formed from a metal on the Al electrodes of LSI chips are bonded under pressure to the electrodes of wiring on a circuit board by means of a photo-curing insulating resin. In this case, the electrodes on both sides are electrically connected only by the contracting force of the resin. As described above, the method requires the bumps to be formed directly on the Al electrodes of LSI chips. In a conventional method of forming the bumps directly on the Al electrodes, a multi-layer metal film composed of Cr-Cu or Ti-Pd, called a barrier metal, is formed on the Al electrodes of the LSI chips, followed by the formation of the bumps thereon by electrolytic plating. However, such direct formation of the bumps on the Al electrodes of LSI chips requires a sequence of deposition, photolithographic, and etching processes to be performed. During these processes, the LSI chips may be damaged, which incurs the reduction of production yield, the increase of overall mounting cost, and the deterioration of reliability. Moreover, it is difficult to obtain LSI chips on which bumps are preliminarily formed, so that the conventional method is disadvantageous in that it is lacking in versatility.

As a means to eliminate the above-mentioned disadvantage, for example, Japanese Patent Publication No. 2-7180 discloses a method in which bumps, which have been preliminarily formed on another substrate, are transferred and bonded to the Al electrodes of LSI chips.

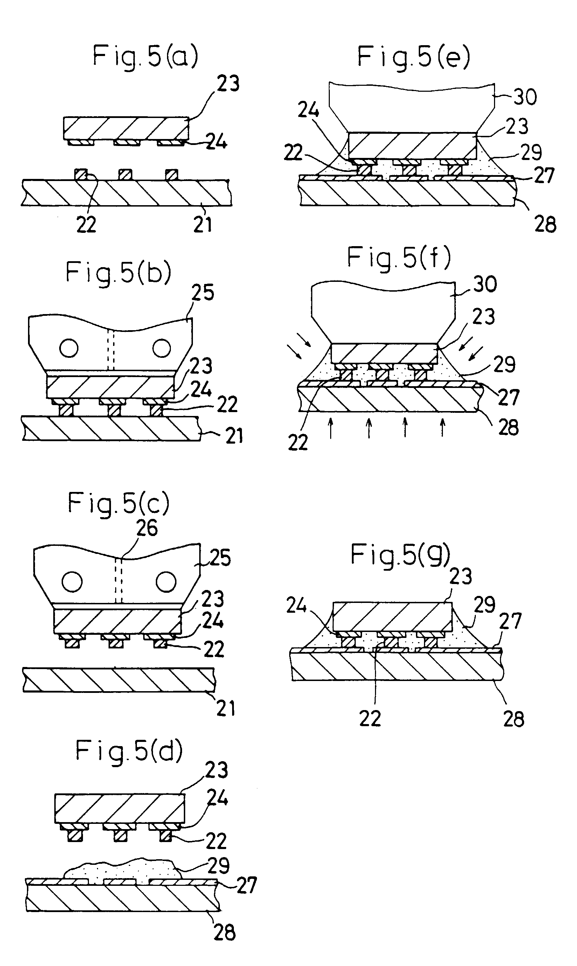

Below, the process of the method, combined with the process of the aforesaid MBB method, will be described with reference to FIGS. 5(a) to 5(g). FIGS. 5(a) to 5(g) are cross sections showing the transition of the conventional fabrication process. A similar process is described in US-A-4 749 120. First, as shown in FIG. 5(a), a substrate 21 for bumps, which is provided with bumps 22 composed of Au, is prepared. The bumps 22 were previously formed on the substrate 21 for bumps chiefly by electrolytic plating. Then, a semiconductor device 23 is positioned over the substrate 21 for bumps so that each of the Al electrodes 24 of the semiconductor device 23 is aligned with respect to the corresponding bump 22.

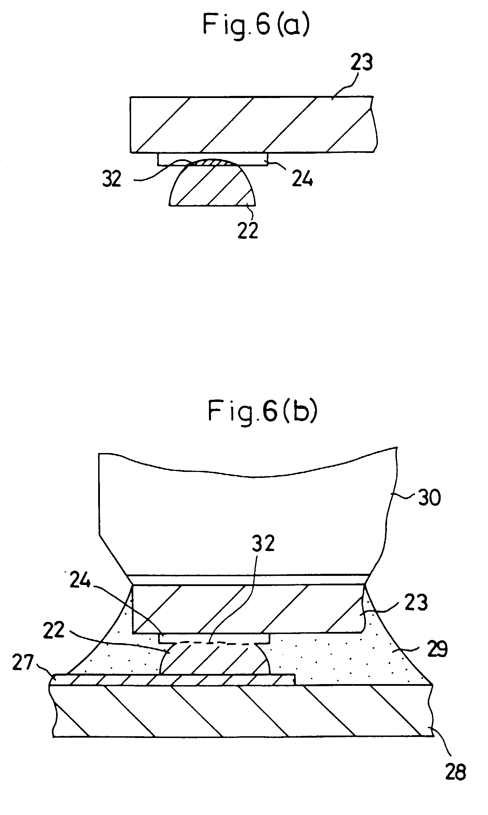

Next, as shown in FIG. 5(b), the semiconductor device 23, with its Al electrodes 24 being in contact with the bumps 22, is pressed and heated from its undersurface by a bonding tool 25. As shown in FIG. 6(a), the pressing and heating process generates an alloy layer 32 between the bumps 22 and Al electrodes 24, so that the bumps 22 are bonded to the Al electrodes 24. The pressing and heating process was performed for approximately 1 sec at a temperature of 380 to 460°C and under a pressure of 7 to 10g per bump. Between the bumps 22 and Al electrodes 24 is formed a Au-Al alloy layer 32. The alloy layer obtained here is extremely thin, because the pressing and heating process mentioned above was performed under the minimum pressure, at the minimum temperature, and for the minimum period of time so that the bumps 22 would not undergo considerable changes in terms of configuration and magnitude.

Subsequently, as shown in FIG. 5(c), the bonding tool 25 is elevated while attracting the semiconductor device 23 with suction through a vacuum suction hole 26 by using a vacuum pump (not shown), so that the bumps 22 are peeled off the substrate 21 for bumps to be transferred to the Al electrodes 24.

Next, as shown in FIG. 5(d), the semiconductor device 23 to which the bumps 22 were transferred and bonded in the preceding process is aligned with respect to a circuit board 28 which has electrodes 27 of wiring in the positions corresponding to the respective bumps 22. Meanwhile, a photo-curing insulating resist 29 is applied to the region of the circuit board 28 corresponding to the semiconductor device 23.

Thereafter, as shown in FIG. 5(e), the bumps 22 are pressed and bonded to the electrodes 27 of wiring by a pressing tool 30 at ordinary temperature. The insulating resin 29, which was interposed therebetween, is thrust away to the surrounding area, so that the bumps 22 are brought into secure electrical connections with the electrodes 27 of wiring. To provide the perfect connections therebetween, the bumps 22 should be deformed considerably. The bumps 22 is deformed to the extent that its thickness, which was about 10 µm prior to the pressing process, is reduced to 4 to 5 µm. The load needed to deform each bump is 90 to 100g per bump.

After that, as shown in FIG. 5(f), the circuit board 28 is irradiated with an ultraviolet ray from its undersurface or side face, so as to cure the photo-curing insulating resin 29.

The application of pressure is then ceased, thereby completing the connections as shown in FIG. 5(g). Thus, in the conventional method, the circuit board 28 and semiconductor device 23 are bonded together under pressure without heating, and then the foregoing two are fixed by means of the photo-curing insulating resin 29. The method, which has improved by overcoming the conventional problems, has the following characteristics:
1. Since non-heating connections are realized, a thermal stress is not induced.
2. The connecting members are insusceptible to the thermal stress induced by the difference in coefficient of thermal expansion since they are bonded together (kept in contact) merely by the application of pressure.
3. The method is applicable to a narrower pitch since metallic bonds are not involved in the bonds between the bonded members.

However, the foregoing conventional method has the following disadvantage.

As described above, the Au-Al alloy layer 32 which was formed between the bumps 22 and Al electrodes 24 in the first transferring/bonding step is extremely thin, as shown in FIG. 6(a). This is because it is sufficient for the Au-Al alloy layer 32 to provide the binding force necessary to peel the bumps 22 off the substrate 21 for bumps and that, if the bumps 22 are considerably deformed, mal-connection may be caused in the subsequent process. That is, if a large pressure and heat at a high temperature are applied or if the bonding process is continued for a long period of time, the columnar bumps 22 formed by electrolytic plating or other technique will be deformed considerably, resulting in the mal-connection between the bumps 22 and electrodes 27 of wiring in the following process. Therefore, the bumps 22 are transferred onto the Al electrodes 24 without substantially being deformed.

Thereafter, the bumps 22 are greatly deformed under a heavy load of 90 to 100g per bump without being heated so as to be pressed onto the electrodes 27 of wiring on the circuit board 28 (see FIG. 5(e)), as described above. However, as shown in FIG. 6(b), the Au-Al alloy layer 32 is ruptured upon the considerable deformation of the bumps 22, so that the resulting fragments of the Au-Al alloy layer 32 which was continuously formed in the preceding process are scattered over the vicinity of the interface between the bumps 22 and Al electrodes 24. Hence, the region other than the fragmentary Au-Al alloy layer 32 in the vicinity of their interface is seldom alloyed, resulting in less reliable bonding in terms of strength.

If a reliability test such as the high-temperature standing test is performed with the junction formed by the fabrication method, the contact resistance between the bumps 22 and Al electrodes 24 is disadvantageously increased in a relatively short period of time. If the test is further continued, electrical connections will be severed completely in the end. In the case where the circuit board and semiconductor device have different coefficients of thermal expansion and the resulting semiconductor apparatus is used at a high temperature, in particular, a large stress is induced between the semiconductor device 23 and Al electrodes 24 due to the difference in coefficient of thermal expansion therebetween, so that even the bonds between the semiconductor device 23 and Al electrodes 24 may be destroyed.

Another method is described in EP-A-0208494. These a method is disclosed for connecting two semiconductor devices. Metal bumps are formed on a substrate corresponding to electrodes on one semiconductor device. These bumps are transferred to these electrodes. A second semiconductor device is pressed with its electrodes against the bumps. During pressing and additional heating, the bumps provide a connection between the respective electrodes of the two semiconductor devices. In order to produce a firm connection, during this pressing and heating step, the pressure it set to 50 to 200 g on each bump and the temperature is set to 350 to 500°C. Further in JP-A-6290959 a similar manufacture method is described.

### SUMMARY OF THE INVENTION

An object of the present invention is to provide a method of fabricating a semiconductor apparatus in which the electrodes of a semiconductor device are connected to electrodes of wiring via bumps, whereby the bumps are transferred and bonded to the electrodes of the semiconductor device, the bumps are aligned with respect to the electrodes of wiring, and then the electrodes of the semiconductor device and bumps are subjected to a re-alloying process, so as to strengthen the bonds between the electrodes of the semiconductor device and bumps without deteriorating the connections between the electrodes of the semiconductor device and electrodes of wiring.

This object is achieved with a method for fabricating a semiconductor apparatus having the features of claim 1.

With the method described above, the electrodes of the semiconductor device and bumps are pressed and heated in the transferring/bonding step. Consequently, an alloy layer is formed therebetween so as to bond the electrodes of the semiconductor device and bumps. Subsequently, the bumps are transferred from the substrate for bumps to the electrodes of the semiconductor device. Then, the bumps transferred to the semiconductor device are brought into contact with the electrodes of wiring on the circuit board and further pressed and heated in the re-alloying step so as to strengthen the bonds between the bumps and electrodes of the semiconductor device. In the transferring/bonding step, it is sufficient for the bumps to be bonded to the electrodes of the semiconductor device only with the minimum bonding strength, so that the degree of deformation of the bumps can be minimized without deteriorating the connections between the semiconductor device and the circuit board in the subsequent connecting step. In the re-alloying step, larger pressure and heat than those applied in the preceding step are applied with the bumps being aligned with respect to the electrodes of wiring, so that an alloy layer covering a wider range is formed between the electrodes of the semiconductor device and bumps. In this case, even if the bumps are greatly deformed, there will be no mal-connections between the bumps and electrodes of wiring, for the bumps are already aligned and in contact with the electrodes of wiring. Moreover, since the alloy layer covering a wider range is formed between the electrodes of the semiconductor device and bumps, a sufficiently thick alloy layer will be ensured therebetween even if the bumps are considerably deformed thereafter. Consequently, secure bonds can be obtained between the electrodes of the semiconductor device and bumps through the alloying process without causing mal-connections between the electrodes of the semiconductor device and bumps due to the considerable deformation of the bumps. The bonds between the electrodes of the semiconductor device and bumps are sufficiently strong to withstand a stress resulting from the difference in coefficient of thermal expansion between the semiconductor device and circuit board and to prevent the increase in electric resistance between the electrodes of the semiconductor device and bumps or the disconnection therebetween, so that the reliability of the semiconductor apparatus is improved.

In order to form, in the re-alloying process, an alloy layer that covers a wider range than the range covered by the alloy layer in the transferring/bonding process, the method mentioned above can be subdivided into a method of applying a larger pressure, a method of heating at a higher temperature, and a method of applying pressure and heat for a longer period of time.

In the case of applying a larger pressure, fabrication time and cost can be reduced by simultaneously performing the re-alloying process and the connecting process for providing connections between the bumps and electrodes of wiring.

Moreover, by fixing at least said bumps and electrodes of wiring with an insulating resin which was injected into the space therebetween, the semiconductor device is connected to the circuit board while easily preventing the short-circuit between the electrodes of individual semiconductor devices.

The electrode of the semiconductor device is preferably composed of Al or an Al-type alloy and said electrode of wiring is preferably composed of at least one of Au, Ag, Ni, Cu, and an alloy containing one of these metals.

The circuit board can be a printed circuit board which is composed of a plastic board with a circuit formed thereon. In this case, if the resulting semiconductor apparatus is placed in an ambience at high temperature, a large thermal stress is induced at the connecting members of the semiconductor device and printed circuit board due to the large difference in coefficient of thermal expansion therebetween. Since the re-alloying process according to the present invention provides secure bonds between the electrodes of the semiconductor device and bumps, the disconnection therebetween due to the difference in coefficient of thermal expansion between the semiconductor device and printed circuit board can be prevented.

### BRIEF DESCRIPTION OF THE DRAWINGS

FIGS. 1(a) to (h) are cross sections showing the transition of the process of fabricating a semiconductor apparatus in accordance with the following embodiment;
FIGS. 2(a) and 2(b) are cross sections showing the difference between a Au-Al alloy layer in a transferring/bonding process and the Au-Al alloy layer in a re-alloying process;
FIG. 3 is a graph obtained from experimental data which shows dependency of the shear strength between Al electrodes and bumps on the pressure applied and temperature for bonding;
FIG. 4 is a graph showing the results of reliability tests performed on samples which were prepared according to the fabrication method of the present invention and to a conventional fabrication method;
FIGS. 5(a) to 5(g) are cross sections showing the transition of the conventional process of fabricating a semiconductor apparatus; and
FIGS. 6(a) and 6(b) are cross sections showing the difference between the Au-Al alloy layer in the transferring/bonding process and the Au-Al alloy layer in the wiring process in accordance with the conventional fabrication method.

### DETAILED DESCRIPTION OF THE PREFERRED EMBODIMENT

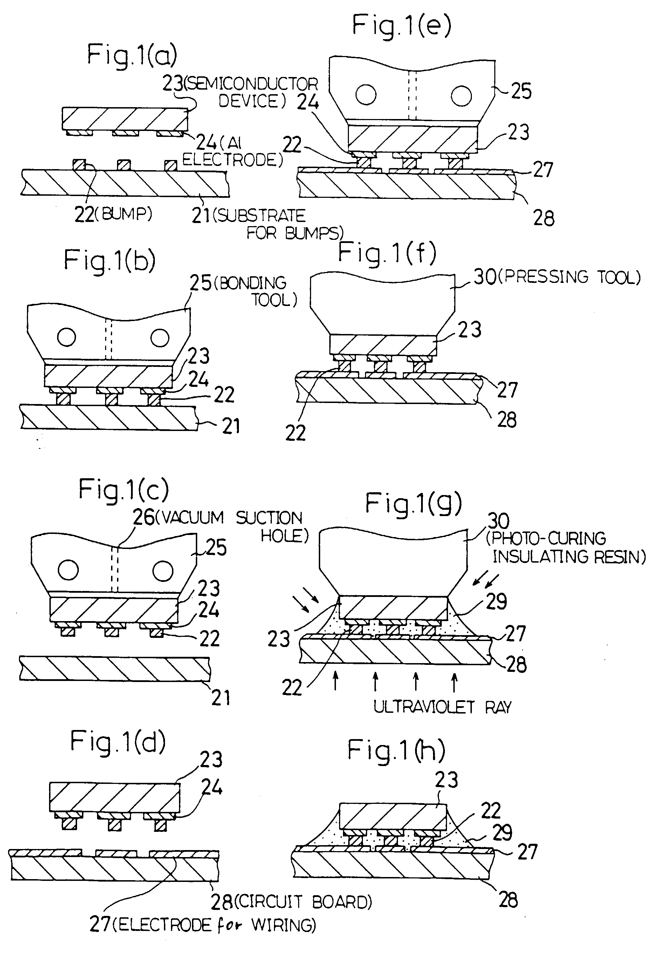

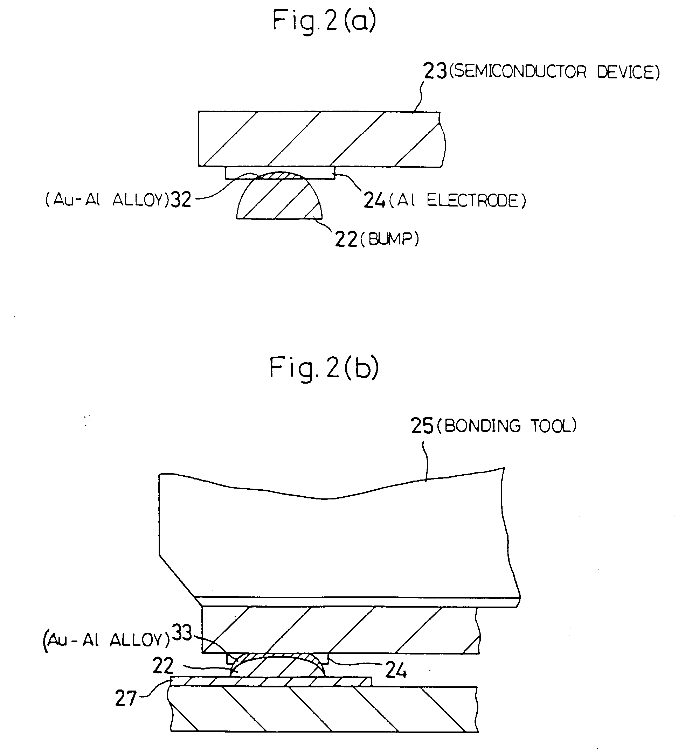

Below, an embodiment of the present invention will be described with reference to FIGS. 1(a) to 1(h) and to FIGS. 2.

FIGS. 1 are cross sections illustrating the step sequence of a method of fabricating a semiconductor apparatus according to the present invention. First, as shown in FIG. 1(a), a semiconductor device 23 is positioned over a substrate 21 for bumps. On the substrate 21 for bumps, bumps 22 composed of Au having a diameter of 30 µm and a height of 10 µm were previously mounted in specified positions by electrolytic plating or other technique, respectively. Then, each of the bumps 22 on the substrate 21 for bumps are aligned with respect to the corresponding Al electrode 24 on the semiconductor device 23.

Next, as shown in FIG. 1(b), a bonding tool 25 with a built-in heating system (not shown) is pressed on to the undersurface of the semiconductor device 23, so as to apply pressure and heat to the bumps 22 and Al electrodes 24. The application of heat and pressure was conducted for 1 sec at a temperature of 380 to 460°C and under a pressure of 7 to 10g per bump. Thus, the bumps 22 on the substrate 21 for bumps are loosely bonded to the Al electrodes 24 of the semiconductor device 23. Since the bonding tool 25 is provided with the heating system, the bottom portion thereof is composed of a heat-resistant material.

Next, as shown in FIG. 1(c), the bonding tool 25 is elevated while attracting the semiconductor device 23 with suction through a vacuum suction hole 26 by using a vacuum pump (not shown), so that the bumps 22 are peeled off the substrate 21 for bumps to be transferred and bonded to the Al electrodes 24 of the semiconductor device 23. FIGS. 1(a) and 1(c) illustrate the transferring/bonding process.

As a result, the bumps 22 composed of Au are bonded to the Al electrodes 24 with a thin Au-Al alloy layer 32 formed therebetween. Since the Au-Al alloy layer formed between the bumps 22 and the Al electrodes 24 is primarily for peeling the bumps 22 off the substrate 21, the temperature, pressure, and time used in the formation of the Au-Al alloy layer 32, which were also required to fulfill the transfer conditions, were minimized. Consequently, the bumps 22 are not substantially deformed under the bonding conditions. For example, the height of the bump 22 which was about 10 µm before the transferring/bonding process is reduced only by 1 to 2 µm.

Next, as shown in FIG. 1(d), a circuit board 28 such as a printed circuit board on which the electrodes 27 of wiring are formed is placed under the semiconductor device 23 to which the bumps 22 were transferred and bonded in the preceding process. The circuit board 28 is placed so that the positions of the electrodes 27 of wiring correspond to the positions of the Al electrodes 24 of the semiconductor device 23. Consequently, the bumps 22 are aligned with respect to the Al electrodes 24 and therefore to the electrodes 27 of wiring. The circuit board 28 is composed of glass, for example. The electrodes 27 of wiring are composed of a material such as Cr-Au, Ti-Pd-Au, or ITO.

Subsequently, as shown in FIG. 1(e), the semiconductor device 23 is heated and pressed by the foregoing bonding tool 25, so that the bumps 22 are bonded to the electrodes 27 of wiring. In this case, the bonding process is performed for 1 to 2 sec at a temperature in the same range of 380 to 460°C as that of the transferring/bonding process (shown in FIG. 1(b)) described above and under a pressure of 70 to 100g per bump, which is about ten times larger than the pressure used in the transferring/bonding process. However, it is also possible to set the temperature at a value higher than that of the preceding transferring/bonding process within the range of 380 to 460°C and to set the heating period at, e.g., 3 to 7 sec, which is longer than that of the transferring/bonding process. With the bonding process, the bumps 22 and Al electrodes 24 are alloyed again. The re-alloying process is illustrated in FIG. 1(e). In the present embodiment, the surface of the foregoing bonding tool 25 was composed of ceramic coated with a diamond thin film.

As shown in FIG. 2(b), a Au-Al alloy layer 33 which was newly formed in the foregoing re-alloying process covers a wider range than the range covered by the Au-Al alloy layer 32 which was formed in the foregoing transferring/bonding process, so that the bumps 22 and the electrodes 27 of wiring are bonded more securely. In this case, the bumps 22 was deformed so that its height reached 4 to 5 µm.

Next, as shown in FIG. 1(f), the heat and pressure applied by the bonding tool 25 are removed, and then the semiconductor device 23 is pressed again by a pressing tool 30 at ordinary temperature. The pressure applied is 70 to 100g per bump, similarly to the foregoing re-alloying process. Since the bumps 22 are pressed against the electrodes 27 of wiring at ordinary temperature, the process does not bring about re-alloying between the bumps 22 and electrodes 27 of wiring. However, the pressing process increases the accuracy with which the semiconductor device 23 is mounted in a specified position of the circuit board 28 and the strength with which the semiconductor device 23 and the circuit board 28 are connected. Since the pressing tool 30 is not heated, the bottom portion thereof is not necessarily composed of such a heat-resistant material as constitutes the bottom portion of the foregoing bonding tool 25. Instead, a material which can easily realize a high degree of flatness, such as glass, is used to constitute the bottom portion of the pressing tool 30.

After that, as shown in FIG. 1(g), an insulating resin is injected into the space between the semiconductor device 23 and circuit board 28. In this case, a photo-curing insulating resin 29 is used. The photo-curing insulating resin 29 can be injected only to the region in which the bumps 22 are formed, or alternatively, over the entire surface of the semiconductor substrate 23. Subsequently, the undersurface or side face of the circuit board 28 is irradiated with an ultraviolet ray, thereby curing the photo-curing insulating resin 29.

Then, as shown in FIG. 1(h), the pressure being applied is removed, thus completing the process of connecting the semiconductor device 23 to the circuit board 28.

In the foregoing embodiment, the re-alloying process (see FIG. 1(e)) was introduced after the transferring/bonding process (see FIGS. 1(b) and 1(c)), so that the bonds between the Al electrodes 24 of the semiconductor device 23 and the bumps 22 are strengthened. As shown in FIG. 2(a), when the bumps 22 were transferred and bonded to the Al electrodes 24 of the semiconductor device 23, the Au-Al alloy layer 32 required only to transfer the bumps 22 to the Al electrodes 24 was formed therebetween. If more pressure and heat are applied, the bumps 22 are greatly deformed, and mal-connections to the circuit board 28 may be caused after the transfer. In particular, the bumps 22 are generally formed by electrolytic plating into the shape of a column which extends vertically to the surface, so that their shapes are readily transformed by the application of pressure and heat into a spherical shape. In the foregoing embodiment, therefore, the deformation of the bumps 22 in the transferring/bonding process was minimized, so that the reduction in height of the bump 22 was suppressed to 1 to 2 µm.

In the re-alloying process, on the other hand, the undersurfaces of the bumps 22 are in direct contact with the electrodes 27 of wiring of the circuit board 28, so that the connections between the bumps 22 and the electrodes 27 of wiring are ensured even after the bumps 22 are greatly deformed. Accordingly, another pressing and heating treatment was performed under a larger pressure and at a higher temperature or for a longer period of pressing and heating so as to newly produce the Au-Al alloy layer 33 extending over a wider range. In this case, the bumps 22 were deformed so that their height reached 4 to 5 µm. Even when the bumps 22 are deformed considerably as described above, the bonds between the Al electrodes 24 and bumps 22 are strengthened to a great extent due to the presence of the sufficiently thick alloy layer between the Al electrodes and bumps. Consequently, even when the difference in coefficient of thermal expansion between the circuit board 28 and the semiconductor device 23 to be mounted on the circuit board 28 is considerably large, the breakage of the bonds which may be caused by a large stress resulting from the large difference in coefficient of thermal expansion can efficiently be prevented in using the semiconductor apparatus, thereby efficiently preventing the increase in contact resistance and the generation of disconnection.

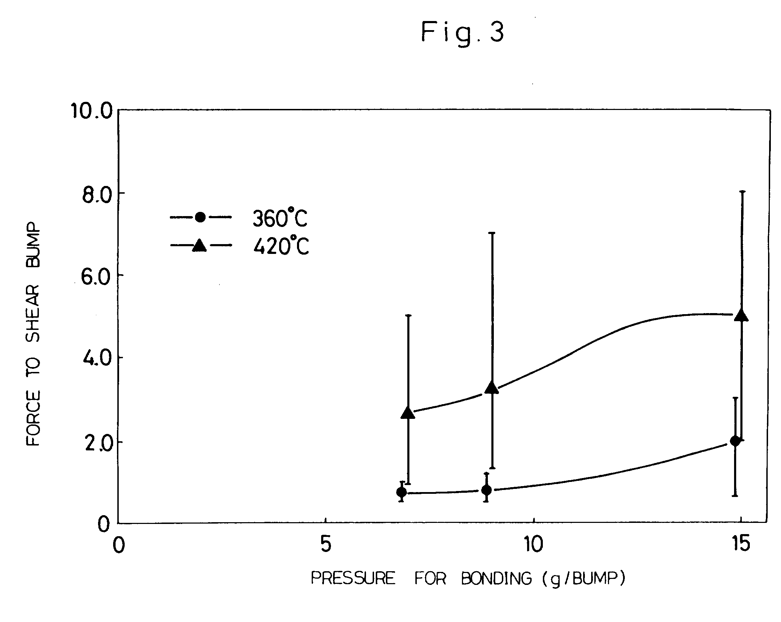

Concrete experiments were conducted on the basis of the foregoing embodiment, the results of which will be described below. FIG. 3 shows the transition of the shear strength (at ordinary temperature) of the bump 22 when the pressure applied and the temperature for bonding are varied. In the drawing, vertical solid lines represent the range in which the measurements obtained for twenty-five samples are varied and marks ▲ and ● represent the mean values of the measurements obtained. As can be appreciated from the drawing, the force to shear a bump becomes larger as the applied pressure becomes larger or the temperature for bonding becomes higher.

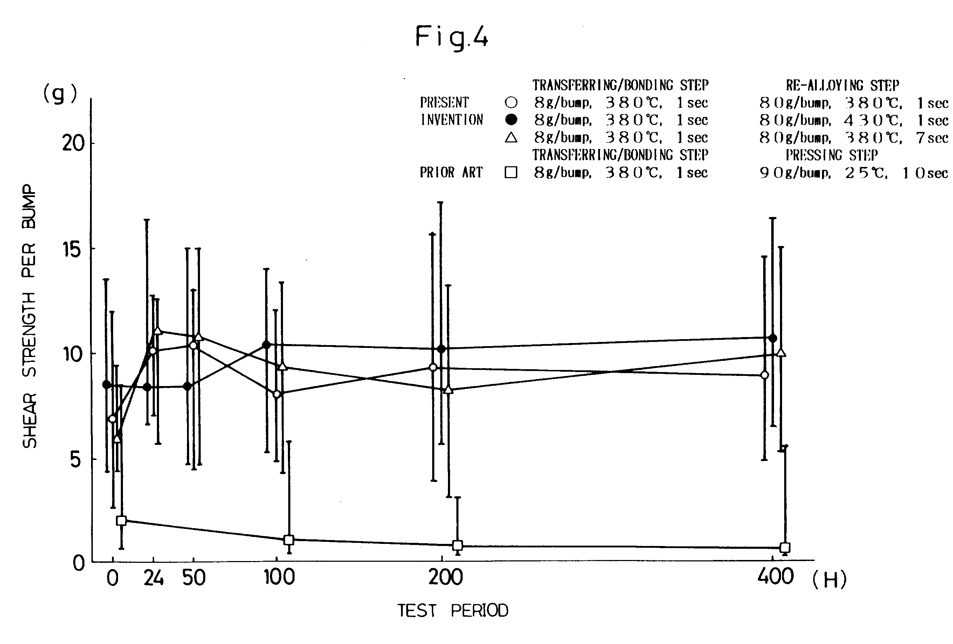

FIG. 4 shows the results of reliability tests for the shear strength per bump at a constantly high temperature of 150°C. The tests were performed for the purpose of comparing the conventional method which does not involve the re-alloying process and the method of the present invention. In the drawing, vertical solid lines represent the range in which the measurements obtained for twenty-five samples are varied and marks ○, ●, △, and □ represent the mean values of the measurements obtained. The marks ○, ●, and △ show the data for samples which were bonded according to the fabrication method of the present invention: ○ indicates a sample which was bonded under a larger pressure; ● indicates a sample which was bonded under a large pressure and at a higher temperature; and △ indicates a sample which was bonded for a longer period of time under a larger pressure and at a moderate temperature. The mark □ shows the data for a sample which was bonded according to the conventional fabrication method, so that the sample was subjected only to the pressing process at ordinary temperature and not to the re-alloying process after the transferring/bonding process. Specific conditions are noted in the drawing. As can be seen from the drawing, the initial shear strength of the sample according to the conventional method was small, and it tended to be considerably lowered before the test period reached 200 hours. Conversely, the initial shear strengths of the samples according to the present invention were large and they did not deteriorate even when the test period was elongated.

Although the Al electrodes 24 of the semiconductor device 23 are composed of Al in the foregoing embodiment, the electrodes of the semiconductor device are often composed in practice of an Al-type alloy such as Al-Cu-Si alloy or Al-Ti-Si alloys, in addition to pure Al. However, the material of the electrodes of the semiconductor device is not limited to Al and Al-type alloys. Although the bumps 22 are composed of Au in the foregoing embodiment, the constituent of the bumps 22 is not limited thereto and a metal other than Au can be used to constitute the bumps 22. In particular, such metals as Cu, Ag, and Ni have small electric resistances and appropriate capabilities for plastic deformation, so that they are suitably interposed between the electrodes of the semiconductor device and the electrodes of wiring to achieve electric connections smoothly.

Although the photo-curing insulating resin 29 was used in the connecting process in order to connect the semiconductor device 23 to the circuit board 28 in the foregoing embodiment, it will be easily understood that a thermo-curing or other resin or a conductive material can be used instead. In this case, there are two types of methods to employ the insulating resin: the insulating resin can be injected after the re-alloying process by the application of pressure and heat, as described in the foregoing embodiment; or it can be preliminarily applied onto the circuit board 28 after the alignment of the bumps 22 with respect to the electrodes 27 of wiring in the process illustrated in FIG. 1(d), followed by the application of heat and pressure as shown in FIGS. 1(e) and 1(f), so as to be cured by the irradiation of an ultraviolet ray or by the application of heat as shown in FIG. 1(g).

### INDUSTRIALLY APPLICABLE FIELD

The present invention is applicable to a method of fabricating a semiconductor apparatus, such as a memory card, liquid-crystal display, and EL display, in which semiconductor devices including LSI chips are mounted on a print circuit board.

## Claims

1. A method of fabricating a semiconductor apparatus provided with a circuit board (28) made of glass or plastics on which electrodes(27) for wiring are formed with a semiconductor device (23) on which electrodes (24) are formed so as to be connected to said electrodes (27) for wiring via bumps (22) when said semiconductor device (23) is mounted in said circuit board (28), said method comprising:
a preparation step of preliminarily forming a substrate (21) for bumps (22) on which said bumps (22) are positioned corresponding to the electrodes (24) of said semiconductor device (23);
a transferring/bonding step of opposing said semiconductor device (23) to the substrate (21) for bumps (22) so that the electrodes (24) of said semiconductor device are aligned with respect to the bumps (22), applying a pressure to either of said semiconductor device (23) and said substrate (21) for bumps so that one is pressed against the other, heating said electrodes (24) of the semiconductor device and said bumps (22) so as to form an alloy layer (32) between said electrodes (24) of the semiconductor device and said bumps (22), and then transferring said bumps from said substrate (21) for bumps to said electrodes (24) of said semiconductor device (22);
a re-alloying step of opposing said semiconductor device (23) to said circuit board (28) so that said bumps (22), which were transferred and bonded to said electrodes (24) of the semiconductor device in said transferring/bonding step, are aligned with respect to said electrodes (27) of wiring, applying a pressure to either of said semiconductor device (23) and said circuit board (28) so that one is pressed against the other, heating said electrodes (24) of said semiconductor device (23) and said bumps (22) so as to form an alloy layer (33) therebetween which covers a wider range and which strengthens the bonds between said electrodes (24) of said semiconductor device (23) and said bumps that were obtained in said transferring/bonding step; and
a subsequent connecting step for strengthening the electrical connection between said bumps (22) and said electrodes (27) for wiring while applying the pressure at ordinary temperature to either of said semiconductor device (23) and said circuit board (28) so that one is pressed against the other after said transferring/bonding step.

2. A method of fabricating a semiconductor apparatus according to claim 1, wherein said pressure applied in said re-alloying step is larger than said pressure applied in said transferring/bonding step.

3. A method of fabricating a semiconductor apparatus according to claim 1 or 2, wherein said heating in said re-alloying step is performed at a higher temperature than the temperature at which said heating in said transferring/bonding step is performed.

4. A method of fabricating a semiconductor apparatus according to claim 1, 2, or 3, wherein the application of heat and pressure in said re-alloying step is performed for a longer period of time than in said transferring/bonding step.

5. A method of fabricating a semiconductor apparatus according to claim 1, 2, 3, or 4, wherein said connecting step for providing connections between said bumps (22) and said electrodes (27) for wiring comprises fixing of said bumps and said electrodes (27) for wiring by means of an insulating resin (29).

6. A method of fabricating a semiconductor apparatus according to claim 1, 2, 3, 4, or 5, wherein said electrodes (24) of the semiconductor device (23) are made of Al or an Al-type alloy and said electrodes (27) for wiring are made of at least one of Au, Ag, Ni, Cu, and an alloy containing one of these metals.

## Patentansprüche

1. Verfahren zur Herstellung einer Halbleitervorrichtung, die mit einer Leiterplatte (28), die aus Glas oder Plastik hergestellt ist und auf welcher Verdrahtungselektroden (27) gebildet sind, und mit einem Halbleiterbauelement (23), auf welchem Elektroden (24) gebildet sind, um mit den Verdrahtungselektroden (27) durch Kontakthökker (22) verbunden zu werden, wenn das Halbleiterbauelement (23) in der Leiterplatte (28) montiert wird, versehen ist, mit folgenden Schritten:
- einem Präparationsschritt zum Bilden eines Kontakthöcker- (22) -Substrates (21) im Vorhinein, auf welchem die Kontakthöcker (22) entsprechend den Elektroden (24) des Halbleiterbauelementes (23) angeordnet sind;
- einem Übertragungs-Nerbindungsschritt, der folgendes umfaßt: das Gegenüberanordnen des Halbleiterbauelementes (23) und des Kontakthöcker- (22) -Substrates (21), so daß die Elektroden (24) des Halbleiterbauelementes mit Bezug zu den Kontakthöckern (22) ausgerichtet sind; das Anlegen von Druck an das Halbleiterbauelement (23) bzw. das Kontakthöckersubstrat (21), so daß das eine gegen das andere gepreßt wird; das Heizen der Elektroden (24), des Halbleiterbauelementes und der Kontakthöcker (22) um eine Legierungsschicht (32) zwischen den Elektroden (24) des Halbleiterbauelementes und den Kontakthöckern (22) zu bilden; und dann das Übertragen der Kontakthöcker von dem Kontakthöckersubstrat (21) auf die Elektroden (24) des Halbleiterbauelementes (23);
- einem Nachlegierungsschritt, der folgendes umfaßt: das Gegenüberanordnen des Halbleiterbauelementes (23) und der Leiterplatte (28), so daß die Kontakthöcker (22), welche auf die Elektroden (24) des Halbleiterbauelementes in dem Übertragungs-Nerbindungsschritt übertragen und mit diesem verbunden worden sind, mit bezug zu den Verdrahtungselektroden (27) ausgerichtet sind; das Anlegen eines Druckes an das Halbleiterbauelement (23) bzw. die Leiterplatte (28), so daß sie gegeneinander gepreßt werden; das Heizen der Elektroden (24) des Halbleiterbauelementes (23) und der Kontakthöcker (22), um eine Legierungsschicht (33) dazwischen zu bilden, welche einen größeren Bereich überdeckt und welche die Verbindungen zwischen den Elektroden (24) des Halbleiterbauelementes (23) und den Kontakthöckern, die während des Übertragungs-Nerbindungsschrittes erhalten worden sind, verstärkt; und
- einem darauffolgenden Verbindungsschritt zur Verstärkung der elektrischen Verbindung zwischen den Kontakthöckern (22) und den Verdrahtungselektroden (27), während der Druck bei gewöhnlicher Temperatur an das Halbleiterbauelement (23) bzw. die Leiterplatte (28) angelegt ist, so daß sie gegeneinander gepreßt werden, nach dem Übertragungs-Nerbindungsschritt.

2. Verfahren zur Herstellung einer Halbleitervorrichtung nach Anspruch 1, worin der Druck, der in dem Nachlegierungsschritt angelegt wird, größer ist als der Druck, der in dem Übertragungs-Nerbindungsschritt angelegt wird.

3. Verfahren zur Herstellung einer Halbleitervorrichtung nach Anspruch 1 oder 2, worin das Heizen in dem Nachlegierungsschritt bei einer höheren Temperatur ausgeführt wird, als die Temperatur, bei der das Heizen in dem Übertragungs-/Verbindungsschritt durchgeführt wird.

4. Verfahren zur Herstellung einer Halbleitervorrichtung nach Anspruch 1, 2 oder 3, worin die Anwendung von Hitze und Druck in dem Nachlegierungsschritt für eine längere Zeitdauer durchgeführt wird, als in dem Übertragungs-Nerbindungsschritt.

5. Verfahren zur Herstellung einer Halbleitervorrichtung nach Anspruch 1, 2, 3 oder 4, worin der Verbindungsschritt zur Bereitstellung der Verbindungen zwischen den Kontakthöckern (22) und den Verdrahtungselektroden (27) das Fixieren der Kontakthöcker und der Verdrahtungselektroden (27) mit Hilfe eines isolierenden Harzes (29) umfaßt.

6. Verfahren zur Herstellung einer Halbleitervorrichtung nach Anspruch 1, 2, 3, 4 oder 5, worin die Elektroden (24) des Halbleiterbauelementes (23) aus Al oder einer Legierung vom Al-Typ und die Verdrahtungselektroden (27) aus mindestens einem der Elemente aus der Gruppe Au, Ag, Ni, Cu bzw. einer Legierung, die eines dieser Metalle enthält, gemacht sind.

## Revendications

1. Procédé de fabrication d'un appareil à semi-conducteur muni d'une carte de circuit (28) constitué de verre ou de matière plastique sur lequel des électrodes (27) pour câblage sont formées avec un dispositif à semi-conducteur (23) sur lequel des électrodes (24) sont formées de façon à être connectées auxdites électrodes (27) pour câblage via des bosses (22) lorsque ledit dispositif à semi-conducteur (23) est monté sur ladite carte de circuit (28), ledit procédé comprenant :
une étape de préparation consistant à former préliminairement un substrat (21) pour bosses (22) sur lequel lesdites bosses (22) sont positionnées correspondant aux électrodes (24) dudit dispositif à semi-conducteur (23) ;
une étape de transfert/soudage consistant à opposer ledit dispositif à semi-conducteur (23) au substrat (21) pour bosses (22) de sorte que les électrodes (24) dudit dispositif à semi-conducteur sont alignées par rapport aux bosses (22), à appliquer une pression à l'un quelconque dudit dispositif à semi-conducteur (23) et dudit substrat (21) pour bosses de sorte que le premier est pressé contre l'autre, à chauffer lesdites électrodes (24) dudit dispositif à semi-conducteur et lesdites bosses (22) de façon à former une couche d'alliage (32) entre lesdites électrodes (24) dudit dispositif à semi-conducteur et lesdites bosses (22) et à transférer ensuite lesdites bosses dudit substrat (21) pour bosses sur lesdites électrodes (24) dudit dispositif à semi-conducteur (23) ; une étape de réalliage consistant à opposer ledit dispositif à semi-conducteur (23) à ladite carte de circuit (28) de sorte que les bosses (22), lesquelles ont été transférées et soudées auxdites électrodes (24) dudit dispositif à semi-conducteur dans ladite étape de transfert/soudage, sont alignées par rapport auxdites électrodes (27) pour câblage, à appliquer une pression à l'un quelconque dudit dispositif à semi-conducteur (23) et de ladite carte de circuit (28) de sorte que le premier est pressé contre l'autre, à chauffer lesdites électrodes (24) dudit dispositif à semi-conducteur (23) et lesdites bosses (22) de façon à former une couche d'alliage (33) entre celles-ci qui couvre une plage plus large et qui renforce les connexions entre lesdites électrodes (24) dudit dispositif à semi-conducteur (23) et lesdites bosses qui ont été obtenues dans ladite étape de transfert/soudage et
une étape de connexion ultérieure servant à renforcer la connexion électrique entre lesdites bosses (22) et lesdites électrodes (27) pour câblage tout en appliquant la pression à une température habituelle à l'un quelconque dudit dispositif à semi-conducteur (23) et de ladite carte de circuit (28) de sorte que le premier est pressé contre l'autre après ladite étape de transfert/soudage.

2. Procédé de fabrication d'un appareil à semi-conducteur selon la revendication 1, dans lequel ladite pression appliquée dans ladite étape de réalliage est plus grande que ladite pression appliquée dans ladite étape de transfert/soudage.

3. Procédé de fabrication d'un appareil à semi-conducteur selon la revendication 1 ou 2, dans lequel ledit chauffage dans ladite étape de réalliage est effectué à une température plus élevée que la température à laquelle ledit chauffage dans ladite étape de transfert/soudage est effectué.

4. Procédé de fabrication d'un appareil à semi-conducteur selon la revendication 1, 2 ou 3, dans lequel l'application de la chaleur et de la pression dans ladite étape de réalliage est effectuée pendant une durée plus longue que dans ladite étape de transfert/soudage.

5. Procédé de fabrication d'un appareil à semi-conducteur selon la revendication 1, 2, 3 ou 4, dans lequel ladite étape de connexion pour procurer les connexions entre lesdites bosses (22) et lesdites électrodes (27) pour câblage comprend la fixation desdites bosses et desdites électrodes (27) pour câblage au moyen d'une résine isolante (29).

6. Procédé de fabrication d'un appareil à semi-conducteur selon la revendication 1, 2, 3, 4 ou 5, dans lequel lesdites électrodes (24) du dispositif à semi-conducteur (23) sont constituées d'Al ou d'un alliage du type Al et lesdites électrodes (27) pour câblage sont constituées d'au moins un élément parmi Au, Ag, Ni, Cu et d'un alliage contenant un de ces métaux.
